## Europäisches Patentamt
## European Patent Office
## Office européen des brevets

(19)

(11) Publication number: **0 021 480**
**B1**

(12) **EUROPEAN PATENT SPECIFICATION**

(45) Date of publication of patent specification: **08.06.83**

(51) Int. Cl.³: **B 66 F 9/065**

(21) Application number: **80200505.8**

(22) Date of filing: **28.05.80**

(54) **Self-propelled translation lift apparatus.**

(30) Priority: **12.06.79 IT 4290779**

(43) Date of publication of application:
**07.01.81 Bulletin 81/1**

(45) Publication of the grant of the patent:
**08.06.83 Bulletin 83/23**

(84) Designated Contracting States:
**DE FR GB IT SE**

(56) References cited:
**CH - A - 299 295**
**DE - A - 2 504 185**
**FR - A - 2 085 264**
**FR - A - 2 301 473**
**US - A - 3 198 359**
**US - A - 3 257 014**
**US - A - 3 567 053**
**US - A - 4 034 874**
**US - A - 4 147 263**

(73) Proprietor: **MONCALVI S.p.A.**
**Viale Canton Ticino 16**
**I-27100 Pavia (IT)**

(72) Inventor: **Levi, Silvio**
**Viale Canton Ticino, 16**
**I-27100 Pavia (IT)**

(74) Representative: **Martegani, Franco et al,**
**Ing. Barzanò & Zanardo S.p.A. Via Borgonuovo,**
**10**
**I-20121 Milano (IT)**

Self-propelled translation lift apparatus

As is well known to experts of this particular art the efforts of fork lift truck manufacturers are directed towards increasing to the greatest possible extent the distance by which the raised load projects beyond the front wheels of the vehicles.

Various types of fork lift truck have been proposed for this purpose, but they all comprise certain drawbacks.

In one type, the forks are mounted on a pantograph extender fixed to telescopic lifting cylinders extending vertically from the front of the self-propelled truck. Such a truck has the drawback of a low-rigidity supporting structure, and of supporting the load in a completely jutting disposition beyond its front wheels. This substantially limits the truck capacity and its degree of safety.

In another truck of known type, the forward projecting traverse movement is obtained by complicated articulated parallelogram linkages which, for correct positioning of the load, always require a combination of two movements which are very difficult for the operator, the trajectory of the load movement never being horizontal and varying as a function of the angle between the parallelogram sides.

A lift-apparatus of this type is for example described in the patent DE—A—2 504 185. An examination of the specification and drawings of said patent shows clearly that the horizontal translation of the apparatus can be achieved only by moving the truck on the terrain, with all the risks that this involves if the terrain is uneven, or, with the truck stationary, by causing the articulated parallelogram to perform a combined rotary-cum-translation movement. This because the truck and the lifting apparatus are operatively interconnected.

Moreover, the operating cab of the machine is laterally swept by the arms of the parallelogram, with the risk of "guillotining" the operator.

Another type of truck is known which comprises telescopic arms with a fixed hinging point, a hydraulic parallelogram and a central driving position.

In such trucks, the load is provided with a horizontal trajectory by a combination of two movements which require great attention by the operator, who if he makes a mistake can risk inclining the forks, with consequent damage to the load and dangerous tilting thereof.

A further truck of traditional type comprises a central telescopic arm and a hydraulic parallelogram. It has the same drawbacks as the latter type of said truck, and furthermore the operator's visibility is rather poor because of the central arrangement of the telescopic arm.

A type of truck is also known comprising a horizontally traversing central trellis-type arm and a mechanical parallelogram. However, this has the drawback of a very wide chassis and a consequent lack of operator visibility, there again being the possibility of inclining the forks and tilting the load if mistakes are made in operation.

Finally, it is known from the CH—A—299 295 patent a lifting apparatus in which the apparatus is borne by a pair of arms pivoted on the front side to the top of a girder solid with the truck. The movement of the arms is however obtained via a complicated system of tackles extending heightwise above the truck. In this case, too, with the truck stationary, a perfectly horizontal movement of the apparatus is possible.

The object of the present invention is to provide a translation lift apparatus, e.g. a fork lift truck, fitted with a longitudinal horizontal traverser and of such a structure as to obviate or at least minimise the drawbacks of known trucks as briefly described heretofore.

This object is attained according to the present invention by a translation lift-apparatus comprising a truck on which is mounted a lifting apparatus consisting of a means for taking up the load actuated by an articulated parallelogram system translatable on horizontal guides and operated by oleodynamic cylinders, characterized by the fact that said lifting apparatus is provided with a carriage (16) translatable on horizontal guides (13) provided at the top of a central operating cab (11) having a bearing structure which supports said lifting apparatus, and by the fact that said oleodynamic cylinders (20, 26) all act between said carriage (16) and said articulated parallelogram system.

The structural and operational characteristics of the invention and its advantages over the traditional art will be more apparent from an examination of the description given hereinafter by way of example with reference to the accompanying drawings, in which:

FIGURE 1 is a side elevation showing a fork lift truck according to the invention in its rest state,

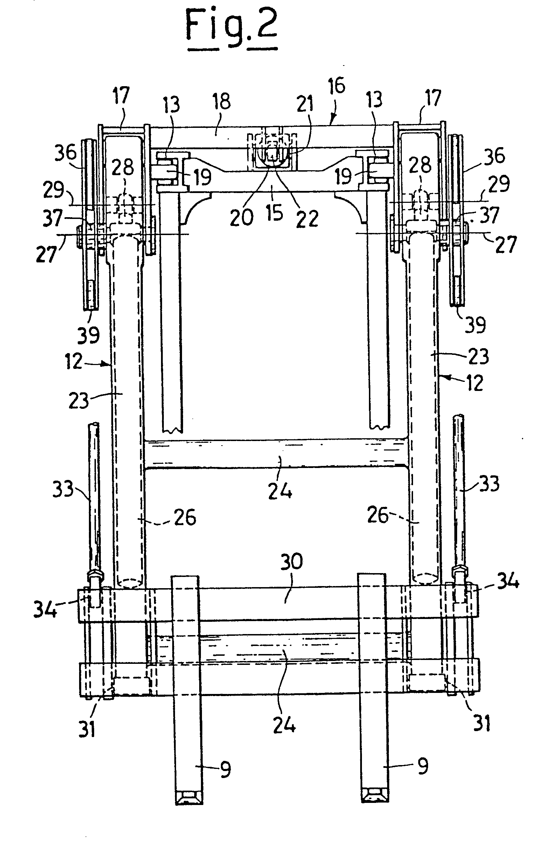

FIGURE 2 is a front elevation on the arrow F of FIGURE 1, with parts of the fork lift truck broken away,

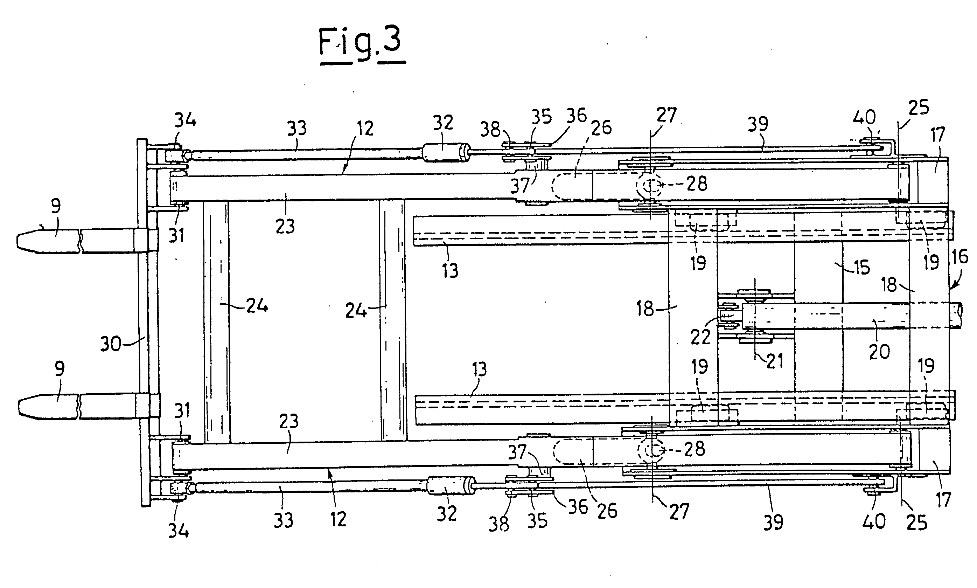

FIGURE 3 is a plan view on the arrow F1 of FIGURE 1,

FIGURES 4 and 5 are diagrammatic views showing the various operational positions of the fork lift truck according to the invention.

With reference to the drawings, the fork lift truck according to the invention comprises a vehicle 10 with a central guide cab 11, on the top of which is mounted the fork lift apparatus 9.

Said apparatus comprises a horizontal traverser indicated overall by 12, which is made to slide on a pair of lateral guides 13 fixed to the top of the load-bearing structure 14 of the driving cab 11 and connected together by a cross-member 15.

The traverser comprises a carriage 16 formed from a pair of longitudinal box beams 17 which are connected together by a pair of terminal cross-members 18. The carriage 16 is mounted on the guides 13 by wheels 19 connected to the beams 17. The traversing movement of the carriage 16 is controlled by a hydraulic cylinder 20 pivoted to the cross-member 15 so as to rotate about the axis 21, and its rod 22 is hinged to the front cross-member 18 of said carriage.

A pair of arms 23, rigidly connected together by cross-members 24, is connected to the beams 17 of the carriage 16.

Said arms 23 rotate about the pivots 25 under the control of a pair of hydraulic cylinders 26, which are hinged to the beams 17 about 27, and have their rods 28 pivoted at 29 to the arms 23. A plate 30 carrying the forks 9 is connected to the free end of the arms 23. The plate 30 can be inclined through a small angle about the pivots 31. The movement of the plate 30 is controlled by a pair of hydraulic cylinders 32, the rod 33 of which is pivoted at 34 to said plate 30. Each cylinder 32 is pivoted in its turn at 35 to one end of an angle lever 36, which is pivoted at an intermediate point 37 to the relative arm 23. At its end distant from the end 35, the lever 36 is pivoted at 38 to one end of a rod 39, the other end of which is pivoted at 40 to the beam 17. A double articulated parallelogram is thus formed.

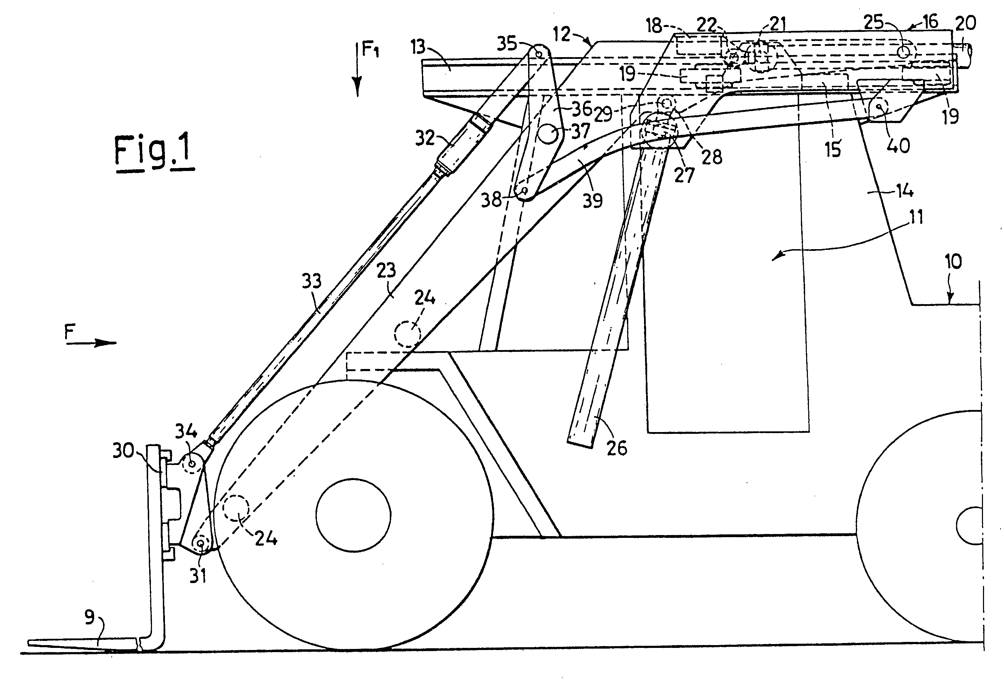

The operation of the fork lift truck according to the invention is apparent from the description given heretofore, and is clearly shown in FIGURES 1, 4 and 5 of the drawings.

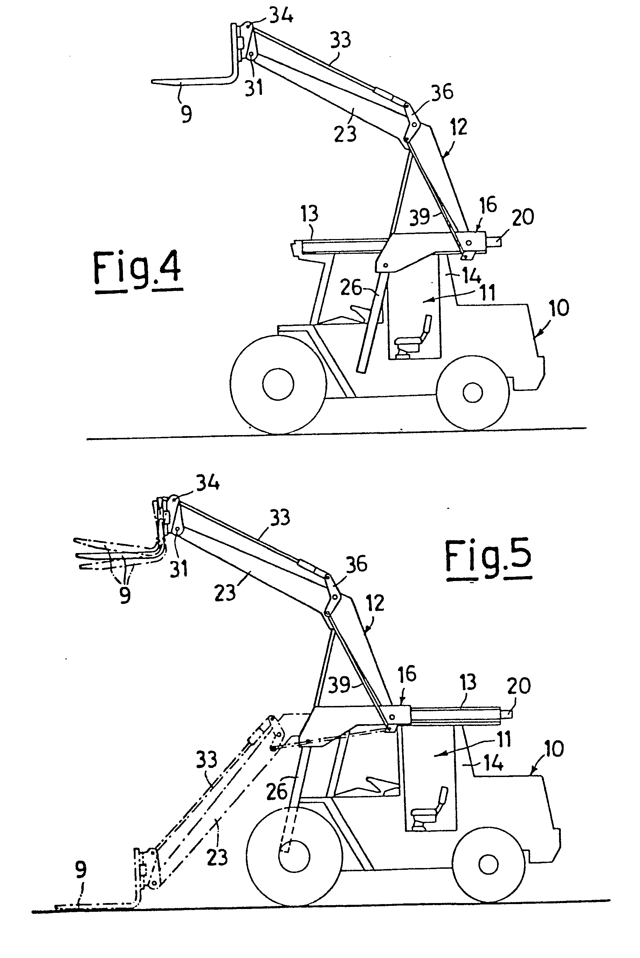

FIGURE 1 shows the fork lift truck in its rest position, with the forks on the ground and the carriage 16 completely withdrawn. Any load on the ground can thus be taken by the forks, raised into the position of FIGURE 4 and then moved horizontally with a forward traversing movement into the position of FIGURE 5, to be then deposited on the required working surface. During these movements, the forks, which always move parallel to themselves, can also be slightly inclined upwards so as to operate under conditions of maximum safety, without any danger of the load falling.

The fork lift truck according to the invention has the following advantages:

1. Its forks are inserted under the load with the machine at rest, with the advantage of being able to operate safely, even on very rough ground.

2. The load is deposited with the machine at rest, with the advantage of being able to operate safely, even on very rough ground.

This requirement is particularly felt when the load is deposited at maximum height.

3. The stroke of the traverser is 10 cm greater than the length of the forks in order to enable them to be released from the load without difficulty.

4. The traverser is situated on the driving cab, giving the following advantages:
— driving position in the centre
— absolute frontal visibility
— total protection of the driving position from moving parts (cylinders, levers, arms etc.)
— easily adjusted micrometric movement without stressing the structures of the drive unit.

5. Ensuring that during load lifting and lowering operations, the load support plane (forks) does not change inclination.

## Claim

A translation lift-apparatus comprising a truck on which is mounted a lifting apparatus consisting of a means for taking up the load actuated by an articulated parallelogram system translatable on horizontal guides (13) and operated by oleodynamic cylinders (20, 26), characterized by the fact that said lifting apparatus is provided with a carriage (16) translatable on the horizontal guides (13) provided at the top of a central operating cab (11) having a bearing structure which supports said lifting apparatus, and by the fact that said oleodynamic cylinders (20, 26) all act between said carriage (16) and said articulated parallelogram system.

## Revendication

Un dispositif élévateur et de translation comprenant un véhicule sur lequel est monté un dispositif de soulèvement consistant en un moyen pour prélever la charge actionné par un système à parallélogrammes articulés déplaçable en coulissement sur des glissières horizontales (13) et actionné par des cylindres oléodynamiques (20, 26), caractérisé par le fait que cet appareil de soulèvement est muni d'un chariot (16) translable sur les glissières horizontales (13) montées à la sommité d'une cabine centrale de conduite (11) ayant une structure porteuse qui supporte cet appareil de soulèvement, et par le fait que ces cylindres oléodynamiques (20, 26) agissent tous entre ce chariot (16) et ce système à parallélogrammes articulés.

## Patentanspruch

Ein bewegliches Hebegerät mit einem Fahrgestell, auf dem eine Hebevorrichtung angeordnet ist, die aus einem, mittels eines auf waagrechten Führungen (13) verschiebbaren, durch oeldynamische Zylinder (20, 26) gesteuerten Gelenkparallelogrammsystems betätigten Lastaufnahmemittel besteht, dadurch gekennzeichnet, dass die besagte Hebevorrichtung mit einem auf den waagrechten Führungen (13) verschiebbaren Wagen (16) versehen ist, welche Führungen oben auf der mittleren Steuerkabine (11) angebracht sind, die einen die genannte Hebevorrichtung tragenden Aufbau besitzt, sowie dadurch, dass die genannten öldynamischen Zylinder (20, 26) alle zwischen dem genannten Wagen (16) und dem genannten Gelenkparallelogrammsystem wirken.

Fig.1

# Fig.2

Fig.3

Fig.4

Fig.5